# EUROPÄISCHE PATENTSCHRIFT

(11) **EP 0 708 934 B1**
(45) Veröffentlichungstag und Bekanntmachung des Hinweises auf die Patenterteilung: **21.10.1998**
(21) Anmeldenummer: 94918745.4
(22) Anmeldetag: 28.06.1994
(51) Int. Cl.: G03F 7/004

(54) **STRAHLUNGSEMPFINDLICHE LACKZUSAMMENSETZUNG**
RADIATION-SENSITIVE PAINT COMPOSITION
COMPOSITION DE PEINTURE SENSIBLE AUX RAYONNEMENTS

(30) Priorität: 12.07.1993 DE 4323289
(43) Veröffentlichungstag der Anmeldung: 01.05.1996
(73) Patentinhaber: SIEMENS AKTIENGESELLSCHAFT, 80333 München (DE)
(72) Erfinder: SEBALD, Michael, D-91093 He dorf (DE); BIRKLE, Siegfried, D-91315 Höchstadt (DE); PREISSNER, Karin, D-91207 Lauf (DE); BESTMANN, Hans-Jürgen, D-91056 Erlangen (DE)
(86) Internationale Anmeldenummer: DE9400740
(87) Internationale Veröffentlichungsnummer: WO9502851

(56) Entgegenhaltungen:
- EP-A- 0 453 610
- US-A- 4 959 293
- PATENT ABSTRACTS OF JAPAN vol. 014, no. 092 (P-1009) 20. Februar 1990 & JP,A,01 300 248 (TOSOH CORP) 4. Dezember 1989

## Beschreibung

Die Erfindung betrifft eine strahlungsempfindliche Lackzusammensetzung sowie ein Verfahren zur Herstellung hochaufgelöster Reliefstrukturen.

In der Halbleiterfertigung werden zur Herstellung feiner Strukturen hochauflösende strahlungsempfindliche Lacke benötigt. Beim lithographischen Prozeß wird ein Substrat mit einer dünnen Schicht eines derartigen Lackes bedeckt und in diese Schicht das gewünschte Muster - durch Projektionsbelichtung oder durch Führen eines Strahls - zunächst als latentes Bild übertragen. Gegebenenfalls nach weiteren Behandlungsschritten, wie Temperung und Silylierung, wird das latente Bild dann entwickelt, wobei in der Lackschicht eine Reliefstruktur (Reliefmuster) entsteht, die als Maske für nachfolgende Substratätzprozesse dient. Das Substrat kann dabei aus einem Halbleitermaterial wie Silicium bestehen oder es kann eine Polymerschicht aus organischem Material sein, d.h. es liegt dann ein sogenannter Zweilagenlack vor (siehe dazu beispielsweise: L.F. Thompson, C.G. Willson, M.J. Bowden "Introduction to Microlithography", ACS Symposium Series 219, American Chemical Society, Washington 1983, Seiten 16, 20 und 21; W.M. Moreau "Semiconductor Lithography", Plenum Press, New York 1988, Seite 4).

Neben einem filmbildenden Basispolymer bildet eine strahlungsaktive Verbindung die Hauptkomponente des Lackes bzw. der Lackschicht. Diese strahlungsaktive Komponente, die im allgemeinen eine Diazoverbindung oder ein sogenanntes Crivellosalz ist, wird durch Absorption der auftreffenden Strahlung, wie sichtbares Licht, nahes UV-Licht (NUV), tiefes UV-Licht (DUV), Röntgenstrahlung, Elektronenstrahlung und Ionenstrahlung, in eine Säure umgewandelt. Diese Säure bewirkt bei positiv arbeitenden, naßentwickelbaren Lacken, gegebenenfalls nach einem Temperprozeß, eine Erhöhung der Löslichkeit der bestrahlten Bereiche in einem Entwickler (siehe dazu: L.F. Thompson et al., a.a.0., Seiten 88 bis 90 und 113 bis 115). Bei negativ arbeitenden, naßentwickelbaren Lacken, beispielsweise sogenannte "Image Reversal"-Lacke, erfolgt in den bestrahlten Bereichen dagegen eine säurekatalysierte Vernetzung, wodurch die Löslichkeit im Entwickler verringert wird (siehe dazu: "Proc. SPIE", Vol. 1086 (1989), Seiten 117 bis 128).

Bei trockenentwickelbaren Lacksystemen wird mit geeigneten gasförmigen oder flüssigen siliciumhaltigen Agenzien eine Silylierung der Lackschicht an der Oberfläche durchgeführt, und zwar bei positiv arbeitenden Lacken selektiv in den unbestrahlten Bereichen und bei negativ arbeitenden Lacken selektiv in den bestrahlten Bereichen. Die Entwicklung erfolgt hierbei in einem anisotropen sauerstoffhaltigen Plasma, wobei die silylierten Bereiche an der Oberfläche der Lackschicht als resistente Ätzmaske dienen (siehe dazu: "Encycl. Polym. Sci. Eng.", Vol. 9 (1987), Seite 132). Sowohl bei naßentwickelbaren als auch bei trockenentwickelbaren Lacksystemen wird ein hohes Auflösungsvermögen durch einen möglichst hohen Säurekonzentrationsunterschied zwischen den bestrahlten und den nicht-bestrahlten Bereichen erzielt.

Aufgrund von Beugungserscheinungen, Linsenfehlern usw. läßt sich eine gegebene Objektstruktur (= Maskenstruktur) mit der Modulation M_{Objekt} = 1 in der Bildebene nur mit einer Modulation M_{Bild} < 1 abbilden, d.h. der Wert für die optische Modulations-Transfer-Funktion (MTF_{Optik} = M_{Bild}/M_{Objekt}) liegt, insbesondere bei feinen abzubildenden Strukturen, deutlich unter dem Maximalwert von 1 (siehe dazu: L.F. Thompson et al., a.a.0., Seite 36; W.M. Moreau, a.a.O., Seite 357).

Das Ergebnis ist eine mit zunehmender Strukturfeinheit zunehmend unschärfere Abbildung der Maskenstruktur in der Bildebene (= Lackebene). Aus diesem Grunde wird die Lackschicht prinzipiell immer auch an den Stellen etwas belichtet, die eigentlich unbelichtet bleiben sollten. Mit zunehmender Strukturfeinheit wird deshalb der Unterschied in der Säurekonzentration zwischen den zu belichtenden und den an sich nicht zu belichtenden Bereichen der Lackschicht immer geringer. Die Auflösungsgrenze des Lackes ist dann erreicht, wenn der Konzentrationsunterschied zu gering ist für ein unterschiedliches Löslichkeitsverhalten (oder auch Silylierungsverhalten) dieser beiden Bereiche, d.h. wenn - für eine gegebene Maskenstruktur - der Wert für die sogenannte kritische Modulations-Transfer-Funktion des Lackes CMTF_{Lack} = (10^{1/γ}-1)/(10^{1/γ}+1) (γ = Kontrast) den Wert der optischen Modulations-Transfer-Funktion übersteigt (MTF_{Optik} < CMTF_{Lack}). Für ein hohes Auflösungsvermögen des Lackes ist deshalb ein hoher Kontrast unabdingbar (siehe dazu auch: W.M. Moreau, a.a.0., Seiten 368 bis 371).

Das Problem besteht nun darin, daß mit herkömmlichen Lackzusammensetzungen, beispielsweise auf der Basis von Novolak-Polymeren und Diazonaphthochinonen oder von t-Boc-geschützten Polymeren und Crivellosalzen, die unerwünschte Entstehung von Säure in denjenigen Bereichen, die an sich unbelichtet bleiben sollten, nicht vermieden werden kann. Der daraus resultierende verringerte Kontrast des Lackes erhöht den Wert für CMTF_{Lack} und begrenzt damit dessen Auflösungsvermögen für feine Strukturen.

Aufgabe der Erfindung ist es, eine strahlungsempfindliche Lackzusammensetzung zur Herstellung hochaufgelöster Reliefstrukturen anzugeben, die eine Kontrastverbesserung ermöglicht, d.h. eine Verbesserung der Auflösung.

Dies wird erfindungsgemäß durch eine Lackzusammensetzung gemäß Anspruch 1 erreicht, die folgende Komponenten aufweist:
- ein filmbildendes Basispolymer
- eine bei Bestrahlung eine Säure freisetzende strahlungsaktive Komponente
- einen speziellen strahlungsempfindlichen Esterbildner und
- ein Lösemittel.

Die Lackzusammensetzung nach der Erfindung weist - neben dem Basispolymer und einer strahlungsaktiven Verbindung (Photosäurebildner) sowie gegebenenfalls weiteren Komponenten - als wesentlichen Bestandteil einen strahlungsempfindlichen Esterbildner auf, d.h. eine Verbindung, die mit der aus der strahlungsaktiven Komponente entstandenen Säure einen Ester bildet. Diesem Vorgang liegt folgende Wirkungsweise des Esterbildners zugrunde.

Die Lichtmodulation in der Resistebene (M_{Bild}) entspricht in etwa dem Konzentrationsprofil der aus der strahlungsaktiven Komponente durch Absorption der Strahlungsenergie gebildeten Säure im latenten Bild. Der strahlungsempfindliche Esterbildner absorbiert die zur Strukturerzeugung dienende Strahlung und verliert dabei die Fähigkeit zur Esterbildung. Entscheidend bei der Lackzusammensetzung nach der Erfindung ist, daß im latenten Bild das Konzentrationsprofil des strahlungsempfindlichen Esterbildners dem Konzentrationsprofil der Photosäure komplementär ist.

Bei der gleichzeitigen Belichtung von strahlungsaktiver Komponente und strahlungsempfindlichem Esterbildner entstehen somit im latenten Bild Bereiche, in denen sowohl Säure als auch Esterbildner vorhanden ist. In einer spontanen oder durch einen nachfolgenden Temperschritt herbeigeführten Reaktion wird in diesen Bereichen die Säure verestert und in eine neutrale Verbindung umgewandelt. Daraus resultiert ein Säurekonzentrationsprofil, das genau unterhalb der Strukturkante auf der Maske einen sprunghaften, d.h. steilen Anstieg zeigt, woraus sich ein wesentlich schärferes und damit kontrastreicheres Bild ergibt. Mit der Lackzusammensetzung nach der Erfindung können somit wesentlich feinere Strukturen als bislang aufgelöst werden.

Als Esterbildner können grundsätzlich solche Verbindungen dienen, welche - spontan oder nach Temperung - mit der aus der strahlungsaktiven Komponente durch Belichtung entstehenden Säure zu einem Ester reagieren und welche die zur Belichtung verwendete Strahlung absorbieren und dabei photochemisch zu Produkten abgebaut werden, die keine Veresterungsreaktion mehr eingehen können; außerdem sollten diese Produkte hydrophil, d.h. im Entwickler löslich sein. Der Esterbildner selbst sollte - ebenso wie der Ester - hydrophob sein, d.h. lösungsinhibierend wirken bzw. im Entwickler unlöslich sein. Im Lacklösemittel sollte der Esterbildner allerdings eine gute Löslichkeit besitzen, und er sollte - im Hinblick auf eine gute Lagerstabilität des Lackes - keine Reaktion mit dem Basispolymer, der strahlungsaktiven Komponente und anderen Lackzusätzen eingehen.

Als Esterbildner dienen Diazoketone der Struktur 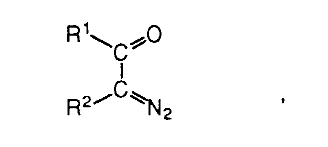 wobei R¹ ein aromatischer oder ein - gesättigter oder ungesättigter - aliphatischer, cyclischer oder heterocyclischer Kohlenwasserstoffrest ist und R² Wasserstoff (H) oder R¹ bedeutet. Die Kohlenwasserstoffreste können auch Substituenten tragen, beispielsweise Halogene sowie O-Alkyl- und Nitrogruppen.

Geeignete Diazoketone sind beispielsweise solche mit substituierten Alkyl-, Cycloalkyl- und Arylresten sowie mit polycyclischen Cycloalkyl- und Arylresten und ferner solche mit mehrfach funktionellen Resten R¹ und R². Als besonders vorteilhaft haben sich folgende Reste R¹ und R² erwiesen: 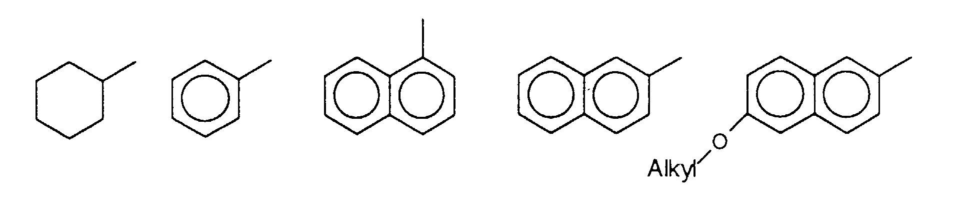 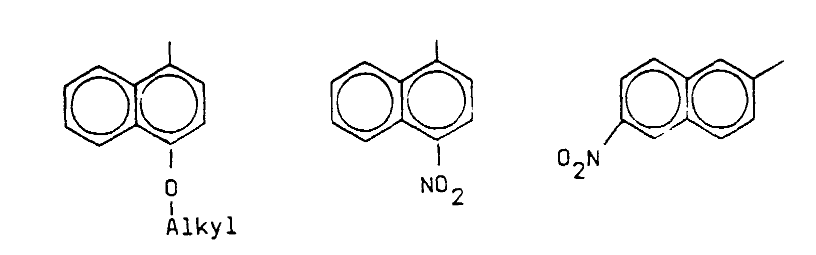 Grundsätzlich sind die Reste R¹ und R² frei wählbar. Es muß allerdings gewährleistet sein, daß bei der Herstellung der Diazoketone auf chemisch-präparativem Weg bei Raumtemperatur stabile Verbindungen erhalten werden, welche außerdem bei der zur Trocknung des Lackes auf der Substratoberfläche erforderlichen Temperatur, die üblicherweise zwischen 50 und 130°C liegt, keine nennenswerte Zersetzung zeigen. Über die Reste R¹ und R² kann auch vorteilhaft die Absorption der Diazoketone an die zur Belichtung verwendete Strahlung angepaßt werden, und ferner können damit die Lösungseigenschaften und die thermische Stabilität beeinflußt werden.

Die Diazoketone reagieren mit der aus der strahlungsaktiven Komponente gebildeten Säure (X-H) unter Stickstoffabspaltung zu einem neutralen Ester: 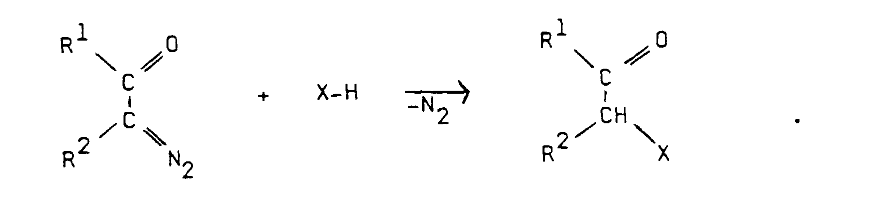 Dabei ist es im Prinzip unerheblich, welche Säure bei der Belichtung aus der strahlungsaktiven komponente gebildet wird. Wichtig ist vielmehr, daß diese Säure mit dem Esterbildner zu einem Ester reagiert.

Der Rest X kann deshalb sowohl ein organischer als auch ein anorganischer oder metallorganischer Rest sein. Beispiele für X sind: Halogen-, 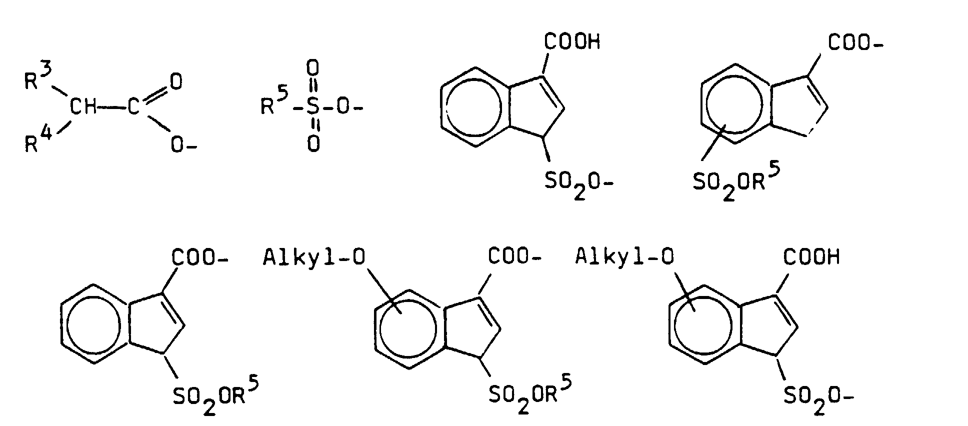 wobei folgendes gilt:
- R³ =: gesättigter oder ungesättigter aliphatischer, cyclischer oder heterocyclischer Kohlenwasserstoffrest (gegebenenfalls halogeniert), Acyl, Alkoxy, Aryloxy, Alkoxycarbonyl oder Aryloxycarbonyl;
- R⁴ =: Wasserstoff, Acyl, Alkoxy, Aryloxy, Alkoxycarbonyl, Aryloxycarbonyl oder halogenierter Kohlenwasserstoffrest;
- R⁵ =: gesättigter oder ungesättigter aliphatischer, cyclischer oder heterocyclischer Kohlenwasserstoffrest, gegebenenfalls halogeniert.

Die als Esterbildner dienenden Diazoketone der vorstehend genannten Art sind strahlungsempfindliche Verbindungen. Bei Belichtung werden sie zersetzt und bilden photochemisch - in Gegenwart von Feuchtigkeit - eine Säure: 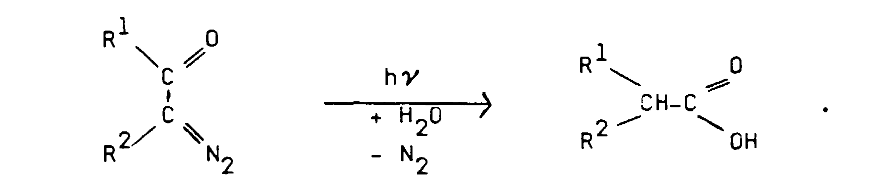 Verbindungen dieser Art sind relativ schwache Säuren, d.h. sie sind nicht in der Lage, mit dem Esterbildner zu reagieren, wie dies die aus der strahlungsaktiven Komponente freigesetzten Säuren tun. Es ist deshalb auch nicht möglich, daß die Diazoverbindungen gleichzeitig als Esterbildner und als photoaktive Komponente agieren.

Der Anteil des Esterbildners in der Lackzusammensetzung bestimmt sich einerseits nach seiner Wirksamkeit gegenüber der aus der strahlungsaktiven Komponente freigesetzten Säure und andererseits nach der Menge der eingesetzten strahlungsaktiven Komponente. Im allgemeinen werden dem Lack, bezogen auf die strahlungsaktive Komponente, 1 bis 200 Mol-% an strahlungsempfindlichem Esterbildner zugegeben; besonders vorteilhaft haben sich Mengen zwischen 10 und 100 Mol-% erwiesen.

Als strahlungsaktive Komponente dienen vorzugsweise Diazodicarbonylverbindungen, Diazochinone, Crivellosalze und Nitrobenzyltosylate. Geeignete Diazodicarbonylverbindungen sind insbesondere Diazoketoester und Diazodiester sowie Diazomeldrumsäure (2,2-Dimethyl-5-diazo-1,3-dioxan-4,6-dion); als Diazochinone eignen sich vor allem Diazonaphthochinone. Geeignete Crivellosalze sind beispielsweise Triflate, d.h. Salze der Trifluormethansulfonsäure, wie Triphenylsulfoniumtriflat. Die strahlungsaktive Komponente wird in einer Menge von 1 bis 100 Gew.-% eingesetzt, bezogen auf das Basispolymer.

Das Polymer enthält vorteilhaft säurelabile Gruppen, wie Epoxy-, tert.-Butylester- und tert.-Butoxycarbonylgruppen (t-Boc-Gruppen); es ist deshalb vorzugsweise ein Copolymer oder Terpolymer mit Monomereinheiten auf der Basis von tert.-Butoxycarbonylmaleinimid. Weitere einsetzbare Polymere sind solche auf der Basis von Novolak oder Kresolnovolak, Polyvinylphenol und Acrylsäure bzw. Methacrylsäure. Ferner eignen sich Styrol-Maleinimid-Copolymere, anhydridhaltige Polymere und siliciumhaltige Polymere.

Als Lösemittel (Lösungsmittel) können insbesondere folgende Verbindungen dienen: Ethylenglykolmonoethyletheracetat, Propylenglykolmonomethyletheracetat, Ethyllactat (Milchsäureethylester), Ethylpyruvat (Brenztraubensäureethylester), Methyl-3-methoxypropionat und Cyclohexanon.

Die Lackzusammensetzung nach der Erfindung ist nicht auf bestimmte Resistsysteme beschränkt. Der Kontrastverbesserung sind vielmehr eine Vielzahl von Lacksystemen der unterschiedlichsten Art zugänglich, wie trocken- und naßentwickelbare Lacke, thermisch entwickelbare Lacke, gefärbte Lacke (dyed resists), Image-Reversal-Lacke, Mehrlagenlacke und Photo-, Röntgenstrahl-, Elektronenstrahl- oder Ionenstrahllacke. Einzelne Beispiele sind: positiv oder negativ arbeitende, naßentwickelbare Einlagenlacke sowie entsprechende trockenentwickelbare Lacke und naß- bzw. trockenentwickelbare, positiv oder negativ arbeitende Zweilagenlacke.

Bei sogenannten säurekatalysierten Lacken, bei welchen bei der Bestrahlung eine starke Säure freigesetzt wird, die - bei einem nachfolgenden Temperschritt - vom Basispolymer Schutzgruppen abspaltet, beispielsweise t-Boc-Gruppen, bietet die Lackzusammensetzung nach der Erfindung - neben der Kontrastverbesserung - den weiteren Vorteil, daß eine Diffusion der Säure aus den bestrahlten Bereichen der Lackschicht in die nicht-bestrahlten Bereiche im Zeitintervall zwischen Bestrahlung und Temperung (= Standzeit) unterbunden wird. Auf diese Weise wird eine Stabilität der Linienbreiten erreicht, und zwar unabhängig von der Standzeit (post exposure delay time stabilization).

Die strahlungsempfindliche Lackzusammensetzung nach der Erfindung wird in lithographischen Verfahren zur Herstellung hochaufgelöster Reliefmuster eingesetzt. Dazu wird diese Lackzusammensetzung zunächst - zur Erzeugung einer strahlungsempfindlichen Lackschicht - auf ein organisches oder anorganisches Substrat aufgebracht und anschließend getrocknet. Zur Erzeugung eines latenten Bildes in der Lackschicht wird diese dann bildmäßig bestrahlt, und zwar mittels Photo-, Röntgen-, Elektronen- oder Ionenstrahlen. Schließlich wird die bestrahlte Lackschicht mit einem gasförmigen oder flüssigen Entwickler behandelt, um das latente Bild in ein Reliefmuster überzuführen, und getrocknet.

Um die Esterbildung zu beschleunigen, ist es vorteilhaft, wenn die Lackschicht nach der bildmäßigen Bestrahlung einem Temperschritt unterworfen wird ("post exposure bake"). Außerdem kann die Lackschicht nach der bildmäßigen Bestrahlung bzw. nach dem Temperschritt mit einem silylierenden Agens behandelt werden ("top surface imaging"). Alternativ kann auch eine Silylierung der Resiststrukturen erfolgen, indem die Lackschicht nach der Behandlung mit dem Entwickler, d.h. nach der Trocknung, mit einem silylierenden Agens behandelt wird. Die Lackschicht kann ferner - zur Bildumkehr ("image reversal") - nach dem Temperschritt noch einer Flutbelichtung unterworfen, d.h. ganzflächig bestrahlt werden. Bei der Behandlung mit dem Entwickler können im übrigen entweder die bestrahlten Bereiche der Lackschicht entfernt werden (positive Lacke) oder die nicht-bestrahlten Bereiche (negative Lacke).

Eine vorteilhafte Ausgestaltung des Verfahrens nach der Erfindung besteht darin, daß die Lackschicht nach der bildmäßigen Bestrahlung bzw. nach dem Temperschritt, aber vor einer gegebenenfalls durchzuführenden Silylierung, einer Flutbelichtung mit einer kürzeren Wellenlänge als bei der bildmäßigen Bestrahlung unterworfen wird. Diese Vorgehensweise ist angebracht, wenn ein Photolack verwendet wird und die bildmäßige Bestrahlung im NUV (Near UV) erfolgt, der Esterbildner aber im DUV (Deep UV) absorbiert. Der Esterbildner wird dann nämlich bei der Flutbelichtung zerstört. Die Flutbelichtung erfolgt beispielsweise mit Strahlung einer Wellenlänge von 250 nm, wenn die bildmäßige Belichtung (im NUV) bei 365 nm (i-line) oder 436 nm (g-line) durchgeführt wurde.

Anhand von Ausführungsbeispielen soll die Erfindung noch näher erläutert werden (MT = Masseteile).

### Beispiel 1 (Vergleichsversuch)

Auf einen Siliciumwafer wird eine Lacklösung aufgeschleudert, die aus 1,74 MT 2,6-Dinitrobenzyltosylat (als strahlungsaktive Komponente), 8,66 MT eines Terpolymers aus N-tert.-Butoxycarbonylmaleinimid, Maleinsäureanhydrid und Styrol (zur Herstellung siehe EP-OS 0 492 253) und 89,6 MT Propylenglykolmonomethyletheracetat besteht. Nach dem Trocknen auf einer Heizplatte (90°C/60 s) wird eine Lackschicht mit einer Dicke von 352 nm erhalten. Diese Schicht wird durch eine Graukeilmaske im Kontaktmodus (Gerät MJB 3, Fa. Karl Süss; Hg-Xe-Lampe) polychromatisch belichtet. Anschließend wird die Lackschicht bei 110°C/60 s auf einer Heizplatte getempert, 120 s im kommerziellen Entwickler NMD-W 2,38 % (Fa. Tokyo Ohka Kogyo Co.) entwickelt, mit Wasser gespült und auf einer Heizplatte 60 s bei 90°C getrocknet. Die Auswertung der Graukeilkurve ergibt einen Kontrast von 1,9 bei einer Empfindlichkeit von 22,8 mJ/cm².

### Beispiel 2

Auf einen Siliciumwafer wird eine Lacklösung aufgeschleudert, die aus 1,61 MT 2,6-Dinitrobenzyltosylat, 8,06 MT eines Terpolymers aus N-tert.-Butoxycarbonylmaleinimid, Maleinsäureanhydrid und Styrol, 0,81 MT (Diazomethyl-2-naphthyl)-keton (als strahlungsempfindlicher Esterbildner) und 89,6 MT Propylenglykolmonomethyletheracetat besteht. Nach dem Trocknen auf einer Heizplatte (90°C/60 s) wird eine Lackschicht mit einer Dicke von 344 nm erhalten. Diese Schicht wird durch eine Graukeilmaske im Kontaktmodus (Gerät MJB 3, Fa. Karl Süss; Hg-Xe-Lampe) polychromatisch belichtet. Anschließend wird die Lackschicht bei 110°C/60 s auf einer Heizplatte getempert, 120 s im kommerziellen Entwickler NMD-W 2,38 % (Fa. Tokyo Ohka Kogyo Co.) entwickelt, mit Wasser gespült und auf einer Heizplatte 60 s bei 90°C getrocknet. Die Auswertung der Graukeilkurve ergibt einen Kontrast von -14,5 bei einer Empfindlichkeit von 31,7 mJ/cm².

### Beispiel 3

Auf einen Siliciumwafer wird eine Lacklösung aufgeschleudert, die aus 1,81 MT 2,6-Dinitrobenzyltosylat, 8,06 MT eines Terpolymers aus N-tert.-Butoxycarbonylmaleinimid, Maleinsäureanhydrid und Styrol, 0,61 MT ω-Diazoacetophenon (als strahlungsempfindlicher Esterbildner) und 89,6 MT Propylenglykolmonomethyletheracetat besteht. Nach dem Trocknen auf einer Heizplatte (70°C/60 s) wird eine Lackschicht mit einer Dicke von 361 nm erhalten. Diese Schicht wird durch eine Graukeilmaske im Kontaktmodus (Gerät MJB 3, Fa. Karl Süss; Hg-Xe-Lampe) polychromatisch belichtet. Anschließend wird die Lackschicht bei 110°C/60 s auf einer Heizplatte getempert, 120 s im kommerziellen Entwickler NMD-W 2,38 % (Fa. Tokyo Ohka Kogyo Co.) entwickelt, mit Wasser gespült und auf einer Heizplatte 60 s bei 90°C getrocknet. Die Auswertung der Graukeilkurve ergibt einen Kontrast von -11,7 bei einer Empfindlichkeit von 28,6 mJ/cm².

### Beispiel 4 (Vergleichsversuch)

Auf einen Siliciumwafer wird eine Lacklösung aufgeschleudert, die aus 2,21 MT Diphenyliodoniumtriflat (als strahlungsaktive Komponente), 16,3 MT eines Copolymers aus N-tert.-Butoxycarbonylmaleinimid und Styrol (Herstellung analog EP-OS 0 492 253; siehe auch EP-OS 0 492 254 sowie EP-OS 0 234 327) und 81,5 MT Ethylenglykolmonoethyletheracetat besteht. Nach dem Trocknen auf einer Heizplatte (90°C/60 s) wird eine Lackschicht mit einer Dicke von 1,2 µm erhalten. Diese Schicht wird durch eine Graukeilmaske im Kontaktmodus (Gerät MJB 3, Fa. Karl Süss; Hg-Xe-Lampe) monochromatisch durch ein 250 nm-Filter belichtet. Anschließend wird die Lackschicht bei 110°C/60 s auf einer Heizplatte getempert, 180 s im kommerziellen Entwickler NMD-W 2,38 % (Fa. Tokyo Ohka Kogyo Co.) entwickelt, mit Wasser gespült und auf einer Heizplatte 60 s bei 90°C getrocknet. Die Auswertung der Graukeilkurve ergibt einen Kontrast von -1,6 bei einer Empfindlichkeit von 5,7 mJ/cm².

### Beispiel 5

Auf einen Siliciumwafer wird eine Lacklösung aufgeschleudert, die aus 2,19 MT Diphenyliodoniumtriflat, 16,2 MT eines Copolymers aus N-tert.-Butoxycarbonylmaleinimid und Styrol, 0,49 MT (Diazomethyl-l-naphthyl)-keton (als strahlungsempfindlicher Esterbildner) und 81,1 MT Ethylenglykolmonoethyletheracetat besteht. Nach dem Trocknen auf einer Heizplatte (90°C/60 s) wird eine Lackschicht mit einer Dicke von 1,2 um erhalten. Diese Schicht wird durch eine Graukeilmaske im Kontaktmodus (Gerät MJB 3, Fa. Karl Süss; Hg-Xe-Lampe) monochromatisch durch ein 250 nm-Filter belichtet. Anschließend wird die Lackschicht bei 110°C/60 s auf einer Heizplatte getempert, 180 s im kommerziellen Entwickler NMD-W 2,38 % (Fa. Tokyo Ohka Kogyo Co.) entwickelt, mit Wasser gespült und auf einer Heizplatte 60 s bei 90°C getrocknet. Die Auswertung aer Graukeilkurve ergibt einen Kontrast von -10,3 bei einer Empfindlichkeit von 7,6 mJ/cm².

Beispiel 5 zeigt - im Vergleich zu Beispiel 4 - deutlich, daß mit der Lackzusammensetzung nach der Erfindung auch bei dicken Photolackschichten eine beträchtliche Kontrastverbesserung zu erzielen ist.

### Beispiel 6 (Vergleichsversuch)

Auf einen Siliciumwafer wird eine Lacklösung aufgeschleudert, die aus 2,21 MT Diphenyliodoniumtriflat, 16,3 MT eines Terpolymers aus N-tert.-Butoxycarbonylmaleinimid, Maleinsäureanhydrid und Styrol und 81,5 MT Propylenglykolmonomethyletheracetat besteht. Nach dem Trocknen auf einer Heizplatte (90°C/60 s) wird eine Lackschicht mit einer Dicke von 1,0 µm erhalten. Diese Schicht wird auf einem KrF-Excimerlaser-Projektionsbelichtungsgerät (λ = 248 nm; numerische Apertur = 0,37) durch eine Maske mit Strukturen zwischen 2,0 und 0,25 µm mit einer Dosis von 28,5 mJ/cm² belichtet. Anschließend wird die Lackschicht bei 110°C/60 s auf einer Heizplatte getempert, 180 s im kommerziellen Entwickler NMD-W 2,38 % (Fa. Tokyo Ohka Kogyo Co.) entwickelt, mit Wasser gespült und auf einer Heizplatte 60 s bei 90°C getrocknet. Die Auswertung der Strukturen im Rasterelektronenmikroskop ergibt eine Auflösung von 2,0 bis 0,7 µm-Strukturen mit Flankenwinkeln zwischen 80° (2,0 µm-Strukturen) und 30° (0,7 µm-Strukturen). Bei den 0,7 µm-Strukturen sind noch 50 % der ursprünglichen Schichtdicke vorhanden.

### Beispiel 7

Auf einen Siliciumwafer wird eine Lacklösung aufgeschleudert, die aus 2,19 MT Diphenyliodoniumtriflat, 16,2 MT eines Terpolymers aus N-tert.-Butoxycarbonylmaleinimid, Maleinsäureanhydrid und Styrol, 0,49 MT (Diazomethyl-1-naphthyl)-keton und 81,1 MT Propylenglykolmonomethyletheracetat besteht. Nach dem Trocknen auf einer Heizplatte (90°C/60 s) wird eine Lackschicht mit einer Dicke von 1,0 µm erhalten. Diese Schicht wird auf einem KrF-Excimerlaser-Projektionsbelichtungsgerät (λ = 248 nm; numerische Apertur = 0,37) durch eine Maske mit Strukturen zwischen 2,0 und 0,25 µm mit einer Dosis von 45,2 mJ/cm² belichtet. Anschließend wird die Lackschicht bei 110°C/60 s auf einer Heizplatte getempert, 180 s im kommerziellen Entwickler NMD-W 2,38 % (Fa. Tokyo Ohka Kogyo Co.) entwickelt, mit Wasser gespült und auf einer Heizplatte 60 s bei 90°C getrocknet. Die Auswertung der Strukturen im Rasterelektronenmikroskop ergibt eine Auflösung von 2,0 bis 0,6 µm-Strukturen mit Flankenwinkeln zwischen 89° (2,0 µm-Strukturen) und 85° (0,6 µm-Strukturen). Bei allen Strukturen ist noch die ursprüngliche Schichtdicke vorhanden.

Beispiel 7 zeigt - im Vergleich zu Beispiel 6 - deutlich, daß mit der Lackzusammensetzung nach der Erfindung sowohl das Auflösungsvermögen als auch die Strukturqualität wesentlich verbessert werden kann.

## Patentansprüche

1. Strahlungsempfindliche Lackzusammensetzung zur Herstellung hochaufgelöster Reliefstrukturen, **gekennzeichnet durch** folgende Bestandteile:
- ein filmbildendes Basispolymer
- eine bei Bestrahlung eine Säure freisetzende strahlungsaktive Komponente
- ein Lösemittel und
- einen strahlungsempfindlichen Esterbildner in Form eines Diazoketons folgender Struktur: 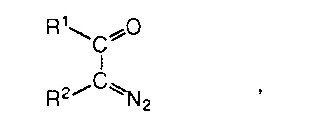 wobei R¹ ein aliphatischer, aromatischer, cyclischer oder heterocyclischer Kohlenwasserstoffrest ist und R² Wasserstoff oder R¹ bedeutet.

2. Lackzusammensetzung nach Anspruch 1, **dadurch gekennzeichnet,** daß der Anteil des strahlungsempfindlichen Esterbildners 1 bis 200 Mol-% beträgt, bezogen auf die strahlungsaktive Komponente.

3. Lackzusammensetzung nach Anspruch 1 oder 2, **dadurch gekennzeichnet,** daß die strahlungsaktive Komponente eine Diazodicarbonylverbindung, ein Diazochinon, ein Crivellosalz oder ein Nitrobenzyltosylat ist.

4. Lackzusammensetzung nach einem der Ansprüche 1 bis 3, **dadurch gekennzeichnet,** daß das Basispolymer säurelabile Gruppen enthält und insbesondere ein Copolymer oder Terpolymer mit von tert.-Butoxycarbonylmaleinimid abgeleiteten Baueinheiten ist.

5. Verfahren zur Herstellung hochaufgelöster Reliefstrukturen, **dadurch gekennzeichnet,** daß eine strahlungsempfindliche Lackzusammensetzung nach einem oder mehreren der Ansprüche 1 bis 4 auf ein Substrat aufgebracht und getrocknet wird, wobei eine strahlungsempfindliche Lackschicht entsteht, daß die Lackschicht bildmäßig bestrahlt wird, wobei in der Lackschicht ein latentes Bild erzeugt wird, und daß die bestrahlte Lackschicht mit einem Entwickler behandelt und anschließend getrocknet wird, wobei das latente Bild in eine Reliefstruktur übergeführt wird.

6. Verfahren nach Anspruch 5, **dadurch gekennzeichnet,** daß die Lackschicht nach der bildmäßigen Bestrahlung getempert wird.

7. Verfahren nach Anspruch 5 oder 6, **dadurch gekenneichnet,** daß die Lackschicht nach der bildmäßigen Bestrahlung bzw. nach der Temperung mit einem silylierenden Agens behandelt wird.

8. Verfahren nach Anspruch 5 oder 6, **dadurch gekennzeichnet,** daß die Lackschicht nach dem Trocknen mit einem silylierenden Agens behandelt wird.

9. Verfahren nach einem der Ansprüche 5 bis 8, **dadurch gekennzeichnet,** daß die Lackschicht nach der bildmäßiqen Bestrahlung bzw. nach der Temperung einer Flutbelichtung mit Strahlung kürzerer Wellenlänge als bei der bildmäßigen Bestrahlung unterworfen wird.

## Claims

1. Radiation-sensitive resist composition for the manufacture of highly resolved relief structures, characterized by the following constituents:
- a film-forming base polymer,
- a radiation-active component which releases an acid during irradiation,
- a solvent, and
- a radiation-sensitive ester former in the form of a diazoketone of the following structure: 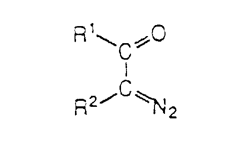 with R¹ being an aliphatic, aromatic, cyclic or heterocyclic hydrocarbon residue and R² signifying hydrogen or R¹.

2. Resist composition according to claim 1, characterized in that the portion of the radiation-sensitive ester former amounts to 1 to 200 mol %, in relation to the radiation-active component.

3. Resist composition according to claim 1 or 2, characterized in that the radiation-active component is a diazodicarbonyl compound, a diazoquinone, a crivello salt or a nitrobenzyltosylate.

4. Resist composition according to one of claims 1 to 3, characterized in that the base polymer contains acid-labile groups and is in particular a copolymer or terpolymer with basic units derived from tert.-butoxycarbonyl maleinimide.

5. Method for the manufacture of highly resolved relief structures, characterized in that a radiation-sensitive resist composition according to one or more of claims 1 to 4 is applied to a substrate and dried, with a radiation-sensitive resist layer being produced, in that the resist layer is irradiated patternwise, with a latent image being produced in the resist layer, and in that the irradiated resist layer is treated by a developer and is subsequently dried, with the latent image being converted into a relief structure.

6. Method according to claim 5, characterized in that the resist layer is tempered after the patternwise irradiation.

7. Method according to claim 5 or 6, characterized in that after the patternwise irradiation and after the tempering the resist layer is treated with a silylating agent.

8. Method according to claim 5 or 6, characterized in that after the drying the resist layer is treated with a silylating agent.

9. Method according to one of claims 5 to 8, characterized in that after the patternwise irradiation and after the tempering the resist layer is subjected to a flood exposure with radiation of a shorter wavelength than in the case of the patternwise irradiation.

## Revendications

1. Composition de laque sensible au rayonnement pour la préparation de structures en relief à haute résolution. caractérisée par les constituants ci-après:
- un polymère de base filmogène.
- un composant actif vis-à-vis du rayonnement libérant un acide lors de l'irradiation,
- un solvant et
- un formateur d'esters sensible au rayonnement sous forme d'une diazocétone répondant à la formule ci-après: 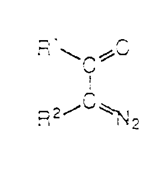 dans laquelle R¹ représente un radical d'hydrocarbure aliphatique. aromatique, cyclique ou hétérocyclique et R² représente un atome d'hydrogène ou représente R¹.

2. Composition de laque selon la revendication 1, caractérisée en ce que la fraction du formateur d'esters sensible au rayonnement s'élève de 1 à 200 % molaires rapportés au composant actif vis-à-vis du rayonnement.

3. Composition de laque selon la revendication 1 ou 2, caractérisée en ce que le composant actif vis-à-vis du rayonnement représente un composé de diazodicarbonyle, une diazoquinone, un sel de Crivello ou un nitrobenzyltosylate.

4. Composition de laque selon l'une quelconque des revendications 1 à 3, caractérisée en ce que le polymère de base contient des groupes labiles en présence d'acides, en particulier un copolymère ou un terpolymère contenant des unités de structure dérivées du tert.-butoxycarbonyl-maléinimide.

5. Procédé pour la préparation de structures en relief à haute résolution, caractérisé en ce qu'on applique sur un substrat et on sèche une composition de laque sensible au rayonnement selon une ou plusieurs des revendications 1 à 4, pour obtenir une couche de laque sensible au rayonnement; en ce qu'on irradie la couche de laque en forme d'image pour obtenir une image latente dans la couche de laque; et en ce qu'on traite avec un révélateur la couche de laque irradiée, puis on la sèche pour transformer l'image latente en une structure en relief.

6. Procédé selon la revendication 5, caractérisé en ce que la couche de laque est soumise à un recuit après l'irradiation en forme d'image.

7. Procédé selon la revendication 5 ou 6, caractérisé en ce qu'on traite la couche de laque après l'irradiation en forme d'image, respectivement après le recuit, avec un agent de silylation.

8. Procédé selon la revendication 5 ou 6, caractérisé en ce qu'on traite la couche de laque après le séchage avec un agent de silylation.

9. Procédé selon l'une quelconque des revendications 5 à 8, caractérisé en ce qu'on soumet la couche de laque, après l'irradiation en forme d'image, respectivement après le recuit, à un éclairage complet avec un rayonnement dont la longueur d'onde est inférieure à celle de l'irradiation en forme d'image.
